# EUROPEAN PATENT SPECIFICATION

(11) **EP 2 647 268 B1**
(45) Date of publication and mention of the grant of the patent: **17.12.2014**
(21) Application number: 11785051.1
(22) Date of filing: 04.11.2011
(51) Int. Cl.: H05K 3/30, H05K 3/34

(54) **WIRE HOLDER AND METHOD OF TERMINATING WIRE CONDUCTORS**
DRAHTHALTER UND VERFAHREN ZUM ABSCHLIESSEN VON DRAHTLEITERN
PORTE-CONDUCTEUR ET PROCÉDÉ DE TERMINAISON DE FILS CONDUCTEURS

(30) Priority: 03.12.2010 US 419777 P
(43) Date of publication of application: 09.10.2013
(73) Proprietor: Volex PLC, Paddington, London W2 6LG (GB)
(72) Inventor: LIU, Yaohsuan, Taipei City 115 (TW); ZHU, Jianghua, Kunshan City Jiangsu Province (GB); HUANG, Donghua, Kunshan City Jiangsu Province (CN); WU, Xinfeng, Kunshan City Jiangsu Province (CN)
(74) Representative: Small, Gary James
(86) International application number: PCT/GB2011/001563
(87) International publication number: WO 2012/072968

(56) References cited:
- WO-A1-2010/030834
- US-A- 5 281 762
- US-A1- 2003 119 343
- US-A1- 2009 197 459
- US-B1- 6 290 532

## Description

### BACKGROUND

The design and production of printed circuit board assembly demands high precision to ensure no loss of signal integrity due to minor imperfections in the printed circuit assembly. In the case of cables and cable connectors, the printed circuit board (PCB) is typically small and encased within a portion of the connector, increasing the difficulty of assembly due to the higher level of precision needed in small PCBs.

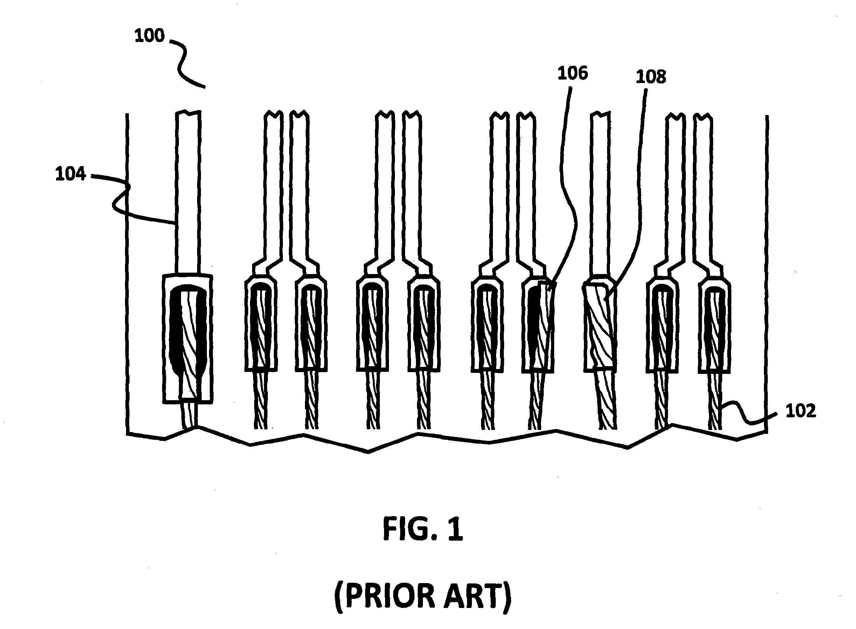

For example, Figure 1 illustrates a row of 10 wires conductors 102 aligned and connecting to the PAD core centers 104 of a PCB 100. In particular, Figure 1 illustrates that in some cases the wires can be skewed, which consequently affects the signal integrity of the cable and connector. During the process of wire termination, it is difficult to terminate every wire exactly in the corresponding trace center due to the spacing between pads being only a few millimeters (mm) or less, depending on the actual product being manufactured. Figure 1 illustrates where the wire terminals meet the PCB viewed at more than 50 times magnification, with the spacing between the wire terminals being only 0.45mm. It is only when the PCB is analyzed and examined at high magnification that minor errors can be detected. However, a user arranging the wires would not be able to appreciate, with the naked eye, subtle shifts in the wires or minor misalignments, resulting in signal degradation. As a consequence, the termination process demands extensive manpower spent on manually adjusting the precise location of wires prior to termination. And, even then, the extensive manpower spent does not guarantee a perfect product.

Product requirements can demand very high performance and signal integrity, and minor defects in the PCB assembly (PCBA) can have detrimental effects on the performance of the end-product. In Figure 1, it was necessary for the wires to be completely aligned with the pad, yet at least the seventh wire 106 and the eighth wire 108 are skewed, impacting the signal integrity of the resulting connector. As mentioned above, while such variations may not appear to be significant, misalignments as illustrated in Figure 1 affect the impedance of the device, especially when operating at higher frequencies. When the terminated metal goes out of the boundary of the corresponding trace, it changes the corresponding impedance, resulting in an impedance mismatch between the objects being connected at the soldering point. The metal used to terminate the seventh and eighth wires 106 and 108 is outside of the corresponding traces. Therefore, there is a need for improving the cable terminating process and a need for ensuring proper alignment of individual wire conductors with the corresponding traces on PCBs.

US 2003/119343 A1 which is considered to represent the closest prior art discloses to terminate a cable having one or more wires within openings of a connector housing.

### SUMMARY OF THE INVENTION

The invention is defined in the appended claims.

A first embodiment comprises a wire holder used to arrange wires and align the individual wire conductors of a cable with the corresponding traces in a printed circuit board (PCB) of a connector housing. The wire holder assists in the manufacturing process of cables and connectors, and especially during the terminating method described herein, by minimizing the amount of time spent by users manually adjusting the wire positions. This consequently improves the accuracy of the terminating location, resulting in a product with high signal integrity.

A second embodiment comprises a PCB holder that protects the printed board circuit assembly and connectors during the manufacturing processing, and especially during the terminating method described herein. The PCB holder provides protection by preventing operators from physically touching the PCB, thus preventing damage to the PCB via an electrostatic discharge (ESD). The PCB holder can further protect the PCB assembly during the manufacturing process by preventing dirt or other foreign substances from falling on the PCB. As the manufacturing process entails the use of various types of machinery, the PCB holder further protects the PCB from getting damaged by the machinery used.

A third embodiment is directed to a method for terminating a cable having one or more wires, comprising the steps of cutting and stripping one or more outer layers of the cable enclosing the one or more wires; arranging the one or more wires on a wire holder; securing the one or more wires to the wire holder; cutting and stripping one or more layers of the one or more wires, the one or more layers enclosing individual wire conductors; dipping the individual wire conductors in a conductive metal; enclosing a PCB within a PCB holder; aligning the individual wire conductors with one or more traces on the PCB within the connector housing; terminating the individual wire conductors to the one or more traces; terminating a ground bar to the PCB; and removing at least a portion of the wire holder from the connector housing.

### BRIEF DESCRIPTION OF THE SEVERAL VIEWS OF THE DRAWING

Figure 1 is a prior art illustration of a partially broken view of a row of wires welded to a PCB, where two of the wires are not properly aligned with the corresponding traces on the PCB;
Figure 2 illustrates a wire holder used to hold and align a set of top wires and a set of bottom wires with a top side and a bottom side of a PCB;
Figure 3 illustrates an embodiment of a PCB holder used to protect the PCB assembly of a connector during a manufacturing process;
Figure 4 illustrates a partially broken, detailed view of the wire holder enabling the aligning between the wire conductors and the corresponding traces of the PCB in accordance with an embodiment;
Figures 5A-5C illustrate a first embodiment of a wire holder;
Figures 6A-6D illustrate four alternative embodiments of the wire holder;
Figures 7A and 7B illustrate an embodiment of a cable used to describe embodiments of the termination method;
Figure 8 illustrates a process chart showing the various steps of the termination method;
Figure 9 illustrates the use of a wire comb to denote the areas to be treated on the cable during the termination method in accordance with an embodiment;
Figure 10 illustrates a gluing area for securing wires to a wire holder in accordance with an embodiment; and
Figure 11 illustrates a ground bar terminated to the PCB after the individual wire conductors are terminated.

### DETAILED DESCRIPTION

A first embodiment comprises a wire holder used to arrange wires and to help maintain the alignment of the individual wires, of a cable or a connector, with the corresponding traces in a PCB or other termination point, of a connector housing, prior to and through termination. The wire holder assists in the manufacturing process of cables and connectors, and especially during the termination method described herein, by minimizing the amount of time spent by users manually adjusting individual wire positions. This consequently improves the accuracy of the termination location, resulting in a product with high signal integrity. A plurality of wires is collected into a wire holder and the wire holder is subsequently aligned with the corresponding traces on the PCB prior to the termination of the wires. If the PCB is double sided, then a first set of wires are terminated to the first side of the PCB (side A), the PCB is flipped over, and the second set of wires are terminated to the second side of the PCB (side B). The wire holder can be made from insulation material or from thermal plastics.

A second embodiment comprises a PCB holder that protects the printed circuit board assembly and connectors during manufacturing, and especially during the termination method described herein. The PCB holder provides protection by preventing operators from physically touching the PCB, thus preventing damage to the PCB via an electrostatic discharge (ESD). The PCB holder can further protect the PCB assembly during the manufacturing process by preventing dirt or other foreign substances from falling on the PCB. As the manufacturing process entails the use of various types of machinery, the PCB holder further protects the PCB from getting damaged by the machinery used. Both the PCB holder and the wire holder can be removed after completion of the termination method described herein, even though either the PCB holder or the wire holder may also be removed after alternative steps. Thus, the wire holder and the PCB holder are only used during the manufacturing process and are not part of the finished product. The PCB holder can be made from insulation material or from thermal plastics.

The wire holder and the PCB holder can be used independently of each other. That is, in some manufacturing processes, the wire holder may be necessary, but the PCB holder may not be necessary. Alternatively, the PCB holder can be used in instances where the wire holder may not be necessary. Embodiments can also be used for manufacturing and design of various types of cables, wires and connectors. The wire holder can be used to hold coaxial cables, multicore cables, ribbon cables, shielded cables, and twisted pair cables. Embodiments of the wire holder can also be used for fiber optic cables and high density design cables.

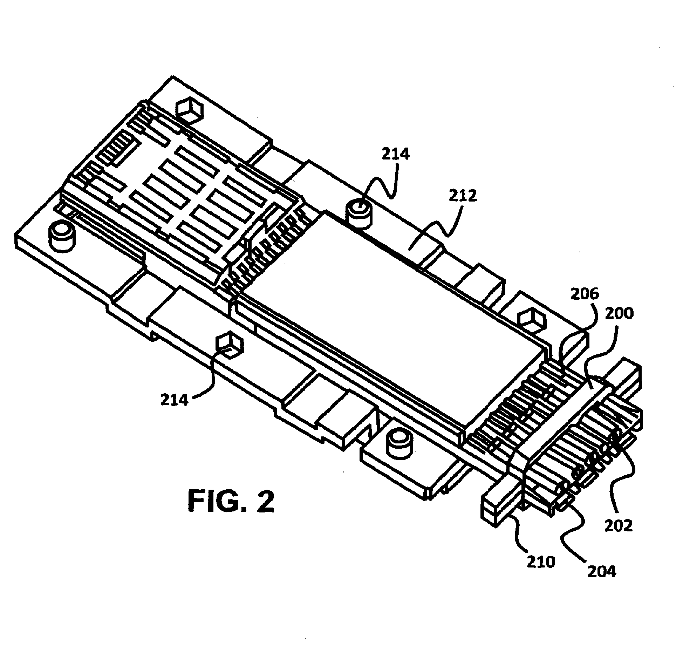

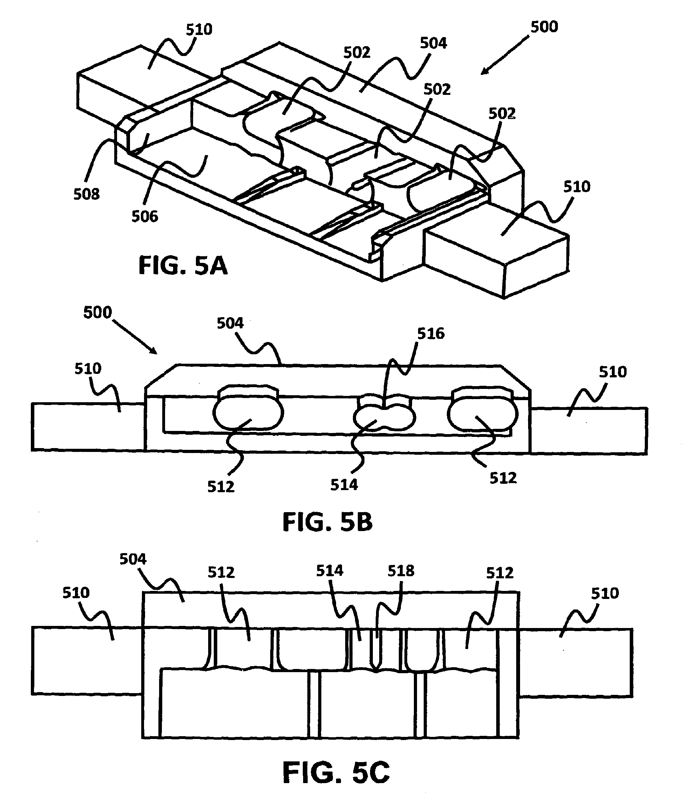

Figure 2 illustrates a wire holder 200 used to hold and align a set of top wires 202. A second wire holder 210 is used to hold and align a set of bottom wires 204. The set of top wires 202 are aligned and terminated to corresponding traces on the top surface of the PCB 206, and the set of bottom wires 204 are aligned and terminated to corresponding traces on the bottom surface of the PCB 206. A detailed view of the wire holder 200 is illustrated on Figure 5. The wire holder includes a plurality of openings fitting individual wires or fitting two or more wires. For instance, small openings can fit individual wires while larger openings can fit two or more wires. The wires can be secured to the wire holder by using adhesive, such as UV glue. Alternatively, the openings of the wire holder can be made to fit snugly around the individual wires, or a fastener can be used to secure the wires to the wire holder.

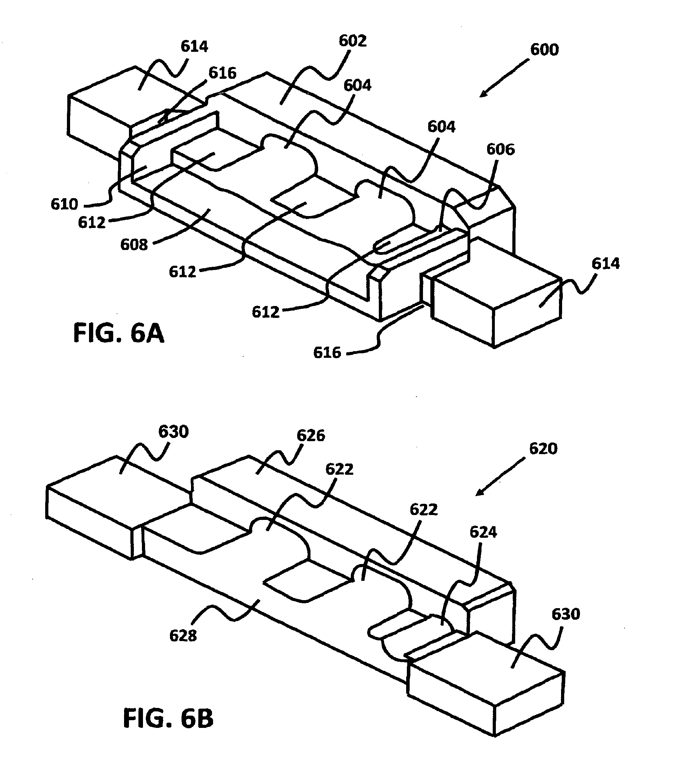

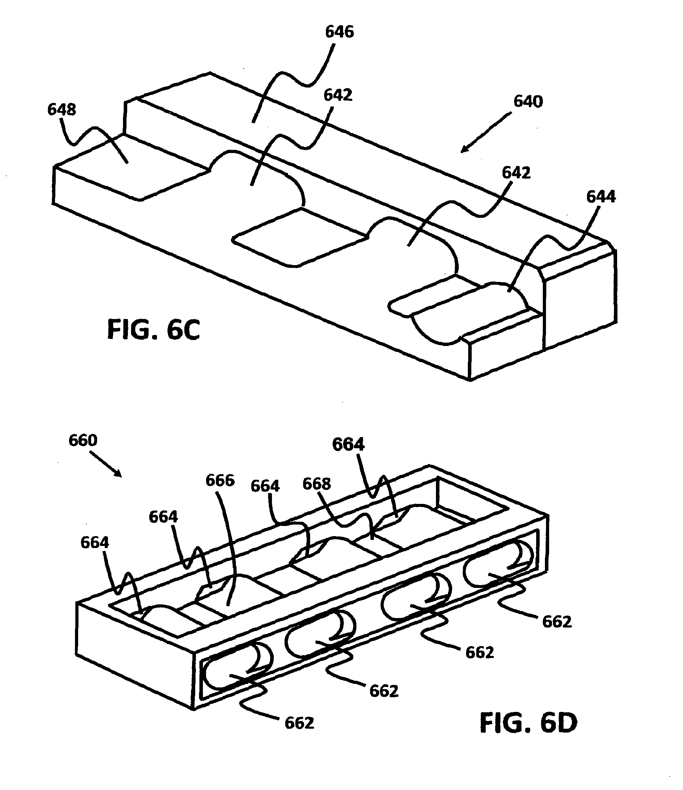

Embodiments of the wire holder can consist of a substantially rectangular structure (a bridge structure) having a set of openings formed on the body of the rectangular structure. The rectangular structure has a width, a length, and a depth, resulting in a substantially rectangular prism shape. The rectangular structure is also described herein as a wall forming a set of openings, with a base formed adjacent to the wall and including a set of grooves that are aligned with the set of openings. These embodiments are discussed further in reference to Figures 5 and 6. In those embodiments, a wire is threaded through the openings of the wire holder body.

In alternative embodiments, the wire holder can consist of one or more matching pieces that fit together, such that when the matching pieces are pieced together, a set of openings are formed between the matching pieces that enable the fitting of wires. In these embodiments, the wires are placed on a base, and the wires are secured in place by attaching locking the other matching pieces to the base. For example, the base can consist of a substantially rectangular portion, while the top matching portion can consist of a c-clamp that fits over the substantially rectangular portion.

Figure 2 illustrates the use of two wire holders, however, alternative embodiments can comprise of a single wire holder having a top c-clamp for holding the top wires 202 and a bottom c-clamp for holding the bottom wires 204. The top c-clamp and the bottom can be secured to each other in various ways. For example, the top c-clamp can have locking sections that lock when pressed firmly against complimentary sections on the bottom c-clamp. The wire holder can include a hinge at one end of the wire holder that maintains the top c-clamp connected to the bottom c-clamp, with the wire holder opening and closing by separating the top c-clamp and the bottom c-clamp at the end opposite the hinge. Alternatively, the top c-clamp and the bottom c-clamp can be aligned, and a securing clamp/clip/fastener can be positioned around both the top c-clamp and the bottom c-clamp. One or more securing clamps or fasteners can be positioned over a first end of the wire holder, over a second end of the wire holder, or over both ends of the wire holder. In yet another embodiment, the top c-clamp can be glued to the bottom c-clamp, resulting in the wires being glued to the wire holder. For instance, UV glue can be applied to the wires and to the wire holder, and a UV dryer can be used to dry the UV glue.

In embodiments of the wire holder consisting of one or more matching pieces that are locked together, the wire holder can consist of a single opening that includes grooves or indentations that facilitate the positioning and arrangement of the wires. Alternatively, the single opening of the wire holder can be smooth and uniform, yet apply a substantial pressure on the wires. If the wire holder consists of a top c-clamp and a bottom c-clamp, then when the wire holder is closed the inside surface of the top-c-clamp and the inside surface of the bottom c-clamp can apply substantial pressure on the wires to keep the wires from moving. The inside of the wire holder can also be divided into two or more sections, enabling a first set of wires to be arranged within a first section, a second set of wires to be arranged within a second section, and so on.

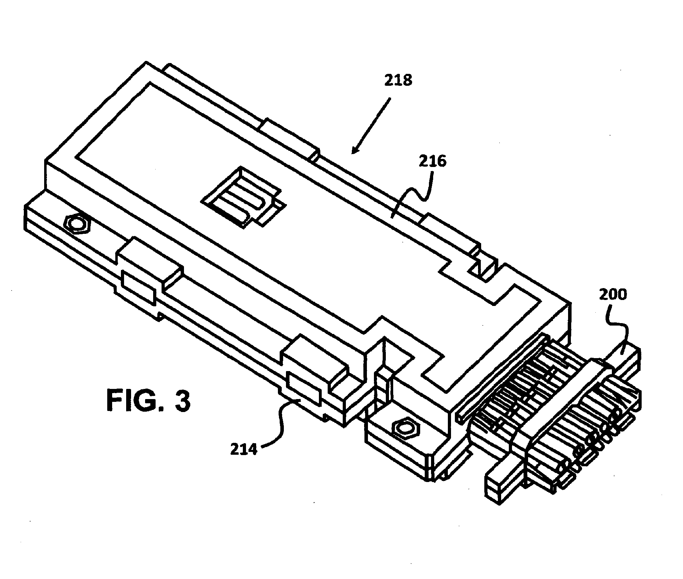

Figure 2 also illustrates a bottom surface 212 of a substantially rectangular shaped PCB holder. The bottom surface 212 of the PCB holder includes locking sections 214 that lock or snap into place against complimentary sections on a top surface 216 of the PCB holder 218 (shown in Figure 3). Figure 3 illustrates the bottom surface 212 secured against the top surface 216 of the PCB holder 218.

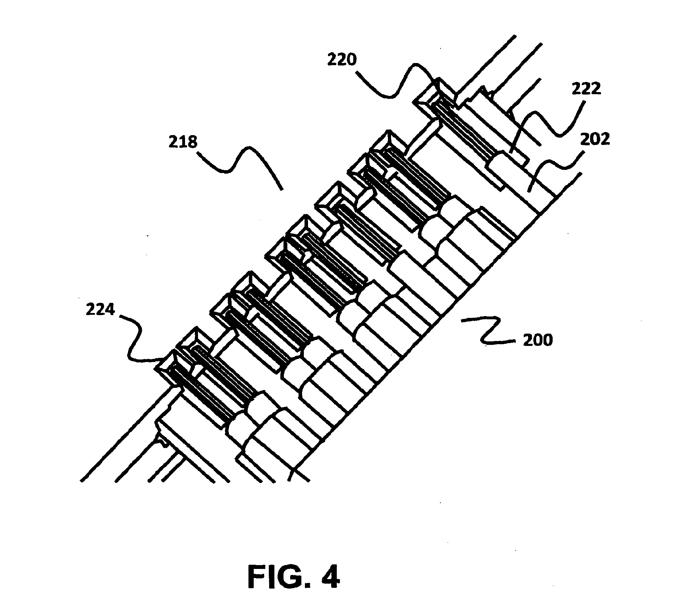

Figure 4 illustrates a partially broken, detailed view of the wire holder 200 that enables the leads 220 of the set of top wires 202 to properly line up with the corresponding traces 222 of the PCB. Figure 4 also shows that the PCB holder 218 can be used to help maintain the alignment of the wires coming into the PCB. The top surface 216 of the PCB holder 218 includes indentations 224 that line up with the corresponding PAD core centers 222. The bottom surface 212 of the PCB holder 218 could likewise include indentations 224 on the reverse side of the PCB. Thus, the wire holder can provide a first level of wire organization and alignment, with the PCB holder ensuring a second level of alignment of the wires coming into the PCB. Alternative embodiments of the PCB holder 218 may not include the indentations 224.

Figures 5A-5C illustrate an embodiment of a wire holder 500. The wire holder includes openings 502 for fitting the wires. The dimensions of the openings 502, the number of openings 502, the spacing between the openings 502, the shape of the openings 502, and the pitch of the openings 502, can all be modified to fit other wires. The wire holder is formed by a substantially rectangular prism body (from herein referred to as bridge structure 504) and a base 506. As noted above, the bridge structure 504 can also be described as a wall having a set of openings formed on the wall for fitting the wires. The bridge structure 504 forms the openings 502, while the base 506 provides a foundation for aligning and positioning the wires by including a set of grooves that are aligned with the openings of the wire holder. The base 506 is substantially rectangular shaped with side walls 508. A pair of substantially rectangular side wings 510 extend laterally from the side walls 508 of the wire holder. The side wings 510 help cut and remove the wire holder after the welding or the soldering steps are completed. The side wings can also be used to secure the wire holder to fixtures used in manufacturing and on the termination method described herein. In some embodiments, only a portion of the wire holder may be removed. For example, where one or more portions of the wire holder are glued in place, a portion of the wire hold may be removed while other portions of the wire holder may be left as part of the connector.

In one embodiment, given a set of requirements and a type of connector to be manufactured, a custom wire holder fitting the wires of the connector can be created.

Figure 5B illustrates a back view of the wire holder 500. The back view illustrates that the wire holder 500 includes two large openings 512, and one middle small opening 514. In addition, while the large openings 512 are substantially ellipsoid shaped, the small opening 514 includes a narrow center 516 resulting in the small opening 514 having a smaller clearance on the middle. Such narrow centers 516 can be used to fit two smaller wires, etc. As noted above, the number of openings, the size of the openings, the shape of the openings, and the spacing of the openings can all be customized for different types of connectors and wires. For instance, the wire holder may include five openings instead of three, with all of the five openings being the same size. Alternatively, the one or more openings can be arranged from small to large. All of the openings can also include a narrow center, or only a subset of the openings may include the narrow center. Openings can also have more than one narrow section and the narrow section need not be centered. The shape and the size of the side wings 510, including height, length, and width can be adjusted as necessary. Figure 5C illustrates a top-down view of the wire holder 500. The top-down view illustrates a divide 518 formed along the middle of the small opening 514, resulting in the smaller opening 514 having the narrow center illustrated on Figure 5B.

Figures 6A-6D illustrate alternative embodiments of the wire holder 500. Figure 6A illustrates a wire holder 600 with a bridge structure 602 forming two large openings 604 and a small opening 606. The wire holder 600 includes a base 608 with side walls 610 and a set of divider walls 612 formed between the various openings of the wire holder 600. The divider walls 612 are relatively low compared to the divider walls of the wire holder 500. In the wire holder 500, the divider walls are as tall as the side walls of the base. A pair of side wings 614 extends laterally from the side walls 610. A side opening 616 is formed between the side wings 614 and the side walls 610. The side opening 616 facilitates the removal of all or a portion of the wire holder by making it easier to remove the side wings 614 from the base 608 of the wire holder.

Figure 6B illustrates yet another embodiment of a wire holder 620. The wire holder 620 includes two large openings 622 and a smaller opening 624. The wire holder further includes side wings 630. The wire holder 620 includes a bridge structure 626 and a short base 628. The base 628 does not include side walls and the length of the base 628 is smaller than then length of the base of the wire holder 600. The wire holder 620 includes side wings 630 extending laterally from the base 628. The wire holder 620 is a smaller wire holder due to its smaller base, and it can be used when a wire holder with a smaller profile is needed.

Figure 6C illustrates an alternative wire holder 640 having a base 648 without sidewalls and without a pair of side wings. The wire holder 640 includes two large openings 642 and one small opening 644 formed by the bridge structure 646.

Figure 6D illustrates an alternative wire holder 660 having a substantially rectangular prism shape. The wire holder 660 includes a set of front openings 662 arranged along a front wall of the rectangular prism, and a set of back openings 664 arranged along a back wall of the rectangular prism and parallel to the front wall. The base of the rectangular prism includes grooves 666 formed between the set of front openings and the set of back openings. Dividing walls 668 are formed between the grooves 666 and define the grooves 666.

A third embodiment is directed to a method of terminating cables, wires, and wire conductors. In an embodiment, steps include at least one or more of the following: raw cable cutting, jacket striping, braid trimming, aluminum foil or shield cutting, arranging wires on a wire holder, UV gluing, UV curing, covering the ends of the wires with an adhesive or textured tape, Side A - laser cutting of wire pair shield or copper mylar, Side A - bending of wire pair shield or copper mylar, Side A - partial striping of wire pair shield or copper mylar, Side A-dipping wire pair braid in tin or an alternative metal trace, Side A-cutting wire pair braid with a laser, Side A-wire pair braid bending, Side A-partial striping of wire pair braid, Side A-cutting of insulation of individual wire with a laser, Side B - laser cutting of wire pair shield or copper mylar, Side B - bending of wire pair shield or copper mylar, Side B - partial striping of wire pair shield or copper mylar, Side B- dipping wire pair braid in tin or an alternative metal trace, Side B-cutting wire pair braid with a laser, Side B-wire pair braid bending, Side B-partial striping of wire pair braid, Side B-cutting of insulation of individual wire with a laser, Side A/B insulation of individual wire partial stripping, dipping wire conductor in tin or an alternative metal trace, cutting of wire conductor to required length, CCD inspection, assembly of PCB holder, aligning the wire holder and the individual wire leads to the PCB, Side A/B terminating of wires to the PCB, CCD inspection, Side A/B hotbar soldering or terminating of ground bar, and removal of at least a part of the wire holder.

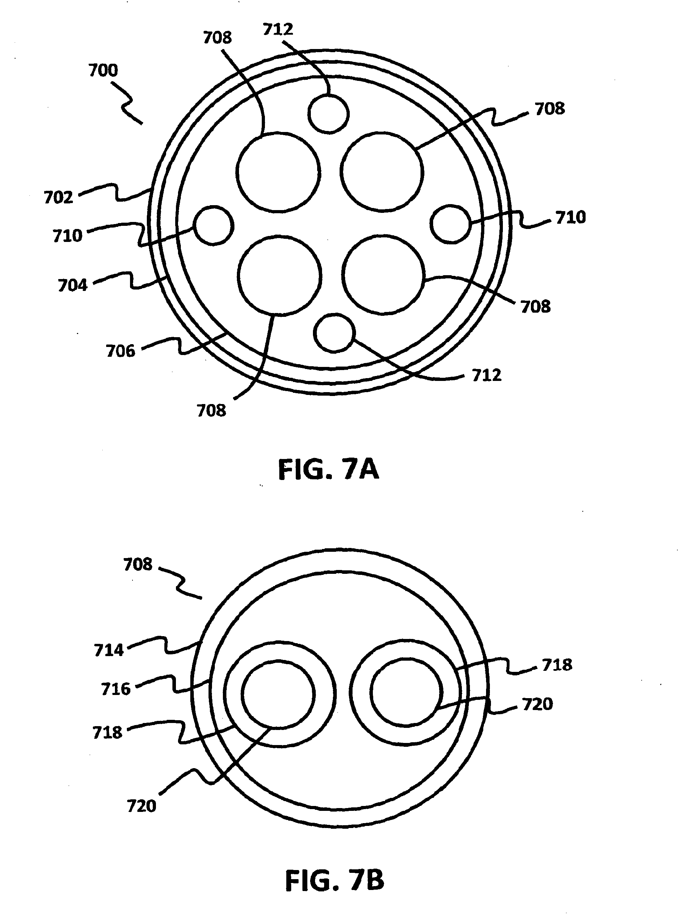

Embodiments of the termination process will be described in terms of the cable illustrated in Figure 7. However, it is to be understood that alternative cables and connectors can be manufactured using the process described herein by omitting or taking the additional necessary steps. Figure 7A illustrates a cable 700 having a cable jacket 702 surrounding a metal braid shielding 704. Inside the metal braid 704 is an aluminum foil shielding 706. Cables are shielded to prevent electromagnetic interference. Inside the aluminum foil shielding 706 are four twisted pair wires 708, two single wires 710, and two ground wires 712. The two single wires 710 and the ground wires 712 consist of an insulator surrounding a conductor. Figure 7B illustrates a twisted pair wire 708 comprised of a wire copper mylar 714 surrounding a wire braid 716. The wire braid 716 encloses the individual wires consisting of an insulator 718 and an inner wire conductor 720. In the description of the termination process, steps will be described which address the stripping and cutting of the various shields and insulators in order to expose the inner wire conductors of the twisted pair wires 708 and the two single wires 710.

When a cable, such as the one illustrated in Figure 7, is to be terminated to a PCB, each wire from each pair has to be properly aligned with the corresponding trace in the PCB. As evident from Figure 7, the wires are not arranged in a straight line, instead the wires are arranged to fit within the volume of the cavity formed by the cylindrical cable. Thus, when wires are pulled out of the cable to be arranged in the PCB, they must be untwisted, and once untwisted it is important to ensure that the wires do not become tangled. In addition, the relative position of each individual wire can make it difficult to align and place the wire securely on the PCB. For example, one of the top wires may need to be connected to the leftmost trace on the top surface of the PCB, while another top wire may need to be connected to the rightmost trace on the bottom surface of the PCB. When the number of wires is large, this process is time consuming. Furthermore, if the wires are not secured (no wire holder is used), bending forces on the wires asserted by virtue of their position within the cable, as well as other forces, can cause some of the wires to move prior to the termination process. Hence, the wire holder helps by enabling an operator to align the wires once, and then to maintain the proper alignment by holding the wires in place.

The wire holder also helps organize wires. Even if the wires are tangled, or if the operator is forced to tangle the wires to achieve the proper connection and alignment of the wires to the PCB, the wire holder helps tame any tendency for the wires to move by keeping the wires in place. The wire holder also enables the alignment of the wires to be set prior to treatment or termination of the wires.

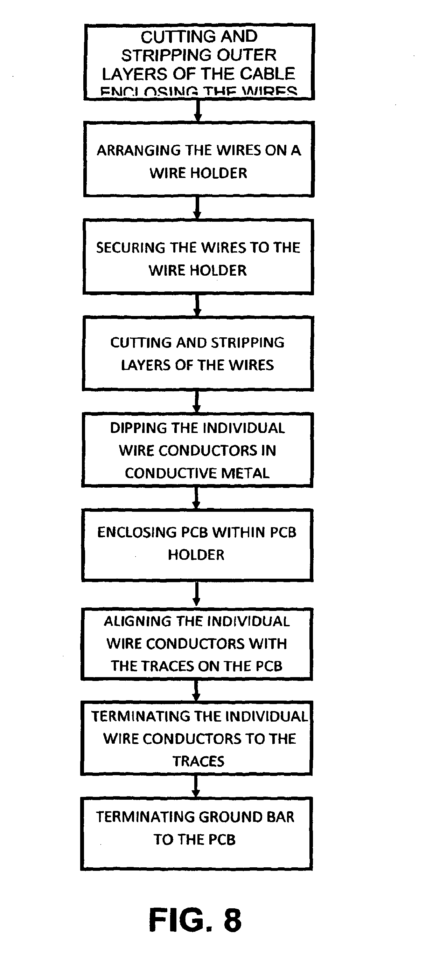

Figure 8 illustrates the steps involved in the termination process. These steps include cutting and stripping one or more outer layers of the cable enclosing the one or more wires; arranging the one or more wires on a wire holder; securing the one or more wires to the wire holder; cutting and stripping one or more layers of the one or more wires, the one or more layers enclosing individual wire conductors; dipping the individual wire conductors in tin or in an alternative metal trace; enclosing a PCB within a PCB holder; aligning the individual wire conductors with one or more traces on the PCB; terminating the individual wire conductors to the one or more traces; and terminating a ground bar to the PCB. The termination process can also include the step of removing at least a portion of the wire holder.

In an embodiment the termination process begins by cutting the raw cable to a desired length. The desired length can be based on a set of requirements, on a set of standards, or on a combination of requirements and standards. For instance, embodiments described herein refer to a raw cable cut to a length of about 1990±5 mm, that is, approximately 2 meters in length. The cutting can be performed manually by an operator. The cutting process can consist of the operator using a ruler and a pair of scissors, with the operator using the ruler to measure the desired or target length of the raw cable, and then using the scissors to cut the raw cable at a point yielding the desired or target length of the raw cable. Embodiments are not limited to the use of scissors, as any equivalent means for cutting the raw cable can be used. Cutting the raw cable can also be automated and it is not limited to manually cutting the raw cable. This step may not be necessary if the process uses raw cables which have already been cut to the desired lengths.

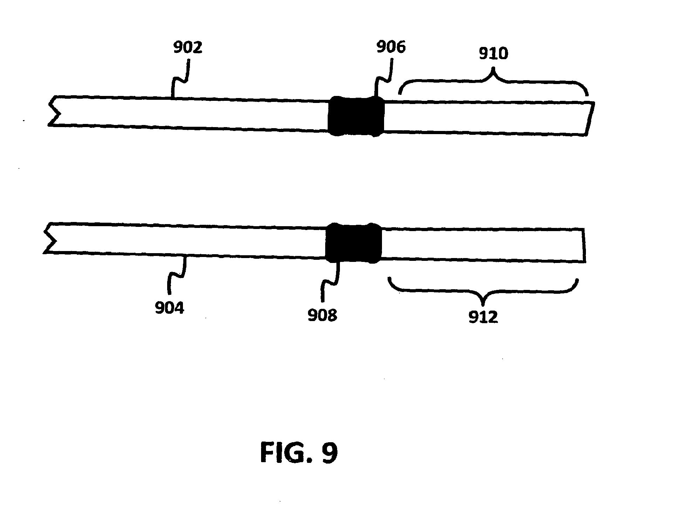

Next, a wire comb is attached or fixed to each end of the cable as illustrated in Figure 9. The figure illustrates a first end 902 and a second end 904 of a cable. A first wire comb 906 and a second wire comb 908 are attached accordingly to the first end 902 and the second end 904. The wire combs 906 and 908 are used to designate portions 910 and 912 of the cable to be handled, prepared, and treated during the termination method. Alternative embodiments can use a clip or a pin instead of a wire comb. In yet another embodiment the edge of the portion of the cable to be treated during the manufacturing process can be marked with ink or with a laser. An adhesive marker or a piece of tape can also be used to designate the portions of the wire to be treated and handled during manufacturing. The portions 910 and 912 to be treated and handled can also be marked with an ink marker.

After the sections of the cable to be treated have been identified, the cable jacket is cut along the edge of the identified sections. For example, a peel knife can be used to cut the cable jacket along the edge of the wire comb. Any other tool or means for cutting the cable jacket can be used to strip the cable, including a pneumatic wire stripping machine. The cable jacket is cut starting at the edge of the designated section to the end of the cable. This results on the end of the cable jacket being removed and resulting on the ends of the cable being exposed.

Stripping the jacket of the cable exposes a shielding braid. Certain cables may not include a shielding braid. If the cable includes a shielding braid, then it is necessary to trim the shielding braid. Tip tweezers can be used to pick out the braid so it can then be removed or moved out of the way. Textured tape can be used to keep the braid out of the way, leaving exposed an aluminum shield. It is to be understood that the braid can be kept out of the way by alternative means, such as by using a clip surrounding portions of the braid, using a wire comb, etc. In some embodiments of the manufacturing process, the shielding braid is cut (to reduce the length of the exposed braid) and soldered to the electromagnetic interference (EMI) cover of the connector.

Diagonal pliers can be used to cut the aluminum shield, and if necessary to also cut redundant single wires. Some cables may not include a braid and/or the aluminum shield. The aluminum shield can be cut, stripped, or removed by any other means. In addition, even if the cable includes a shield made out of a material other than aluminum, it is important to remove the shield to expose the wire pairs, or individual wires, enclosed within the shield.

With the wires exposed, the wires are then arranged on the wire holder based on the connector and PCB design. In the case of twisted pair cables, the wires are first untwisted, and then the untwisted wires are arranged on the wire holder based on the process PCB design. As mentioned above, the wire holder is used to hold the individual wires in a particular and specific order during the manufacturing process. It also helps to organize a plurality of twisted wires into an ordered sequence. It is not necessary to use flat tweezers to untwist the wires, as the twisted wires can be untwisted without any tools (by hand) or by using an alternative tool that does not damage the wires. The wire holder also enables the wires to be aligned accordingly before any further wire termination.

The actual arrangement of the wires will be dependent on the product requirements. The arrangement can be checked under a charge-coupled device (CCD), enabling the arrangement to be checked via high-quality image data, or under a microscope using requirements diagrams. As noted above, if the PCB is double sided, then a first row of wires are arranged on a top part of the wire holder (to be subsequently aligned and welded to side A of the PCB), and a second row of wires are arranged on a bottom part of the wire holder (to be subsequently aligned and welded to side B of the PCB. If the PCB is single sided, then only one row of wires need be arranged on either the top part or the bottom part of the wire holder. Alternatively, a first wire holder can be used to arrange the first row of wires and a second wire holder can be used to arrange the second row of wires.

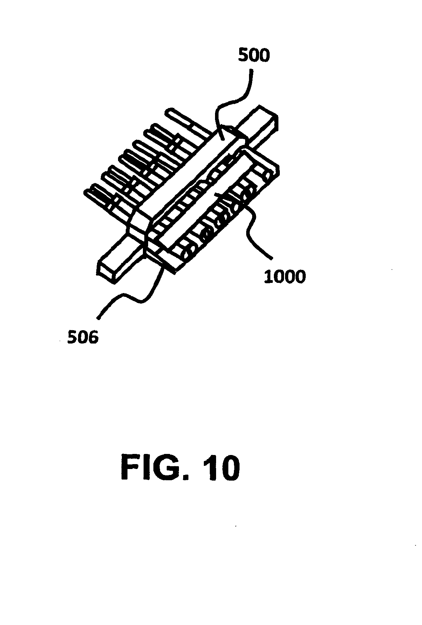

The next step consists of securing the wires in place, such as applying UV glue to the rectangular area 1000 illustrated in Figure 10. Figure 10 shows wire holder 500 and wires threaded through the body of the wire holder 500. Specifically, the rectangular area 1000 includes the area where the wires rest on top of base 506 and where the wires fit on the grooves formed on the base 506, with the grooves guiding the wires into the openings of the wire holder. The UV glue is then UV dried, resulting in the wires being secured to a portion of the wire holder. As noted above, in alternative embodiments the wires can be secured to the wire holder by using a clip that forces together the top part and the bottom part of the wire holder. Alternatively, if using a wire holder with matching pieces that lock together, the top part and the bottom part of the wire holder can be locked by exerting a sufficient force that enables one or more sections on the top part of the wire holder to lock with one or more complimentary sections on the bottom part of the wire holder. Alternatively, a bottom portion can be glued in place to the wires, once arranged, and a top portion can be removed once the wires have been terminated, leaving the bottom portion as part of the finished connector.

Once the wires have been secured to the wire holder, the orientation of the wires is checked, ensuring that the wires are perpendicular to the wire holder. The wires can be checked by placing the wires on a flat surface, thus allowing the angle of the wires to the wire holder to be checked visually. The wires can also be placed on a flat surface having channels fitting wires of various widths, thus ensuring that the wires are straight and are indeed perpendicular to the wire holder. The edge of the wire holder can also be placed against the edge of the flat surface to check the alignment of the wires coming out of the wire holder. Optionally, textured tape or some other adhesive tape can then be placed on the wire ends. Alternatively, various image processing techniques, including cameras and sensors can be used to ensure the wires are in and maintain alignment.

As described herein, the two ends of a cable or connector need not be treated or manufactured using the same termination process described herein. The following sequence of steps is repeated for the wires on side A or side B, or both side A and side B. The sequence of steps will be described in reference to side A, but it is noted that after side A has been treated, the same steps are repeated on side B, if a side B exists. Side A refers to the wires that connect to side A of the PCB, whereas side B refers to the wires that connect to a side B of the PCB, if a side B exists. The side A wires do not have to be treated with all of the following steps before the side B wires are treated. For example, a first step from the following sequence of steps can be performed on side A, followed by performing the first step on side B. Alternatively, two or more steps can be performed on side A, followed by performing the same two or more steps on side B, and so on. As will be noted, not all of the steps are necessary and many of the steps are dependent on the product requirements. Finally, embodiments of the manufacturing process are not limited to connectors having a two-sided PCBA. For a connector having a single sided PCBA, the steps for side A can be performed in order to complete the manufacturing process. Finally, it is to be further understood that in embodiments, steps can be omitted or performed in alternative order without departing from the spirit of the invention.

A subsequent sequence consists of cutting the shield surrounding each pair of wires with a laser. Copper mylar is a material commonly used for the shielding of wire pairs. Laser trimming of such wires is important, as it ensures that the impedance of the cable does not change due to imperfections in the cutting of the cable. The wire ends can be secured on a laser fixture to ensure that the cable is positioned on desired orientation while the laser operates. Any platform or fixture that enables the cable to be held securely can be used during the operation of the laser. In an embodiment, a Yttrium aluminium garnet (YAG) laser is used to cut the shield surrounding the pair of wires, such as copper mylar. This step may not be necessary if the cable does not include a copper mylar shield or if the wire pairs are not individually shielded. The laser fixture can include two openings through which the ends of the cable can be threaded. The ends of the cable can be threaded through the openings until the ends of the cable to be treated are exposed through the opposite end of the openings. The openings can also include a securing mechanism that tightens around the cables and secures the cable during the laser operations. In the case where the wires are to be connected to a double sided PCBA, the set of wires connecting to the top side of the PCBA can be exposed through a first window of the laser fixture, and the set of wires connecting to the bottom side of the PCBA can be exposed through a second window of the laser fixture.

After the shield surrounding each pair of wires is cut with the laser, the wire can be shaken to increase the incision made by the laser, making it subsequently easier to do the partial stripping of the shield. For example, flat tweezers can be used to shake the wire. The benefit of flat tweezers is that they apply even pressure to the wires and thus avoid damaging the wire. The flat tweezers can be used to hold the wires near the incision, and increasing the incision by bending the wire down and bending the wire up. However, alternative embodiments can use other tools to increase the laser incision.

After the incision is increased, the shield, such as the copper mylar, can be partially stripped. This step may not be necessary if the laser incision was sufficiently deep and clean for the partial stripping. When removing the outer layers of the cable which surround the individual wire conductors, the wire holder can be secured in order to enable the wires to be easily manipulated.

A 4F hydraulic wire stripping machine can be used to partially strip the copper mylar shield covering the pair of wires, exposing a wire pair braid enclosing each pair of wires. While the use of a hydraulic wire stripping machine speeds the manufacturing process, alternative embodiments include the manual partial stripping of the shield covering the pair of wires.

The exposed wires are then dipped in tin or in an alternative metal trace. Dipping the wires with the exposed braid in tin preps the wires so that a laser can be used to cut the braid. Dipping the wires in tin enables the laser to make a clean cut on the braid and it prevents the portions of the braid around the laser incision from coming undone.

After the dipping step, a laser is used to cut the dipped braid. In an embodiment, the YAG laser is also used to cut the braid. As mentioned in reference to the shield enclosing each pair of wires (copper mylar), the wire ends can be shaken or slightly moved to increase the incision (such as by user flat tweezers) made by the laser on the braid. While shaking the wires facilitates the partial stripping of the braid, it is not a necessary step.

The next step consists of partially stripping the braids that were dipped in tin and cut with the laser. The braid can be partially stripped using a manual wire stripper or by using a 4F wire stripping machine, using any other suitable wire stripping machine, or by manually stripping the braid.

The last step of the sequence of steps applied to sides A and B consists of using a laser to cut the insulation covering each individual conducting wire, making the conducting wires ready for termination. In an embodiment, a carbon dioxide laser (CO2 laser) is used to cut the insulation of each individual conducting wire. The CO2 laser beam does not damage the wire conductor because the metallic materials are highly reflective to the CO2 laser beam, whereas the insulating materials are generally high absorbing. The laser cuts down to the wire conductor through the insulation, leaving the insulation to be removed. As mentioned above, the laser is used to ensure that the impedance of the resulting cable is not affected by imperfections in the cuts made.

The sequence of steps performed on side A, and discussed above, is subsequently performed on side B with the second row of wires. As noted above, if the PCB is single sided, then the sequence of steps performed on side A are not repeated for side B.

Once the second row of wires has been prepped to the point where the CO2 laser cuts through the insulation, the insulation from both sides A and B is half stripped. This half-stripping process can be performed with a wire stripping machine or it can be performed manually by an operator.

Each individual conductor is then dipped in tin, or in an alternative metal trace. The wires can be dipped using a tin dipping machine or manually by a user. Dipping the wire conductors in tin prevents the wire conductors from splitting or separating into two or more threads. In embodiments, the cable can be secured to a fixture of the tin dipping machine. The fixture would secure the ends of the cable and prevent the rest of the cable from being damaged when the exposed wire conductors are dipped in tin.

The wire conductors are flattened after they are dipped in tin or another conductive material. Flattening the ends of the wire conductors enables a better connection between the wire conductors and the corresponding traces on the PCB. The ends of the wire conductors can be flattened using various techniques. For example, a user can manually flatten the ends of the wire conductors by using flat nose pliers or some other type of pliers. Alternatively, a press machine can be used to flatten the wire conductor ends. After the wire conductor ends are flattened, they are cut to a length based on the PCB assembly.

After the wire leads have been cut, the wires can be inspected using a CCD or a microscope. The inspection consists of checking the laser cuts and the dimensions of the cut wire leads. In an embodiment, image processing can be used to inspect the length of the wire leads and to identify imperfections which may have been introduced during the prepping and treatment of the wires.

The next step consists of enclosing the PCB within the PCB holder. Embodiments of the PCB holder were described above. The PCB holder protects the PCB and the PCB assembly over the following steps and stations, including the terminating steps, which can inadvertent damage the PCB. For example, during welding step, stray molten material produced by the welding process could land on the PCB, damaging the PCB by burning through various leads or components before cooling. After the PCB has been enclosed within the PCB holder, the wire conductors are aligned with the corresponding traces on the PCB. As previously noted, alternative embodiments of the manufacturing process may be performed without the PCB holder and/or without the wire holder.

Once the ends of the wire conductors are aligned with the corresponding traces, the ends of the wire conductors are placed on top of the corresponding traces in the PCB, and the ends of the wire conductors are terminated to the traces of the PCB. In the termination process, one or more PCBs, optionally enclosed within the PCB holder, are placed on a bed that remains stationary while a terminating head moves over the row of wires.

For example, if the termination process consists of welding, a welding head of a welding machine can move over the stationary bed and over the row of wires. The wire holder allows the individual wire conductors to remain aligned during the termination process without the need of a human operator to hold the wires in place. Once the wires on side A of the PCB have been terminated, the bed is then flipped over, and the wires on side B of the PCB are terminated. If the PCB is single sided then there is no need to flip the bed over. After termination, the equality of the termination is checked to ensure that all of the wire leads were properly aligned with the corresponding traces on the PCB.

After termination, a test machine can be used to test the product. Wires can also be prepped differently depending on the dimensions of the wire. For example, if a conductor has a large diameter, then it can also be pressed to enable a good surface contact with the PCB. Alternative embodiments are not limited to a visual inspection. In yet another embodiment, the termination can be further tested by performing a tensile test.

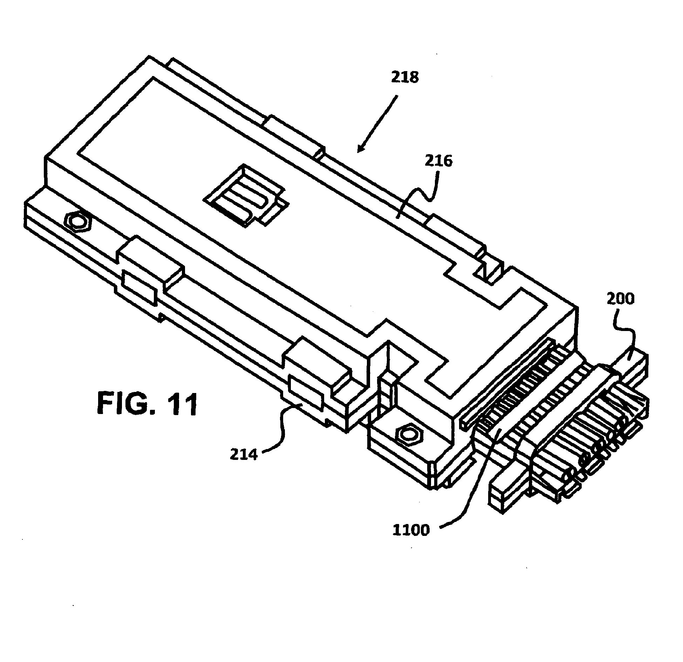

Following the termination of the wire leads, a ground bar or drain wire is added to the shielding braid. For example, the ground bar or drain wire can be added to the shielding braid by using tweezers. A hotbar can subsequently be used to solder the ground bar to the PCB pad. However, an alternative termination process can also be used. If the PCBA is double-sided, as is the case in the example being described herein, a first ground bar is soldered to side A of the PCB and a second ground bar is soldered to side B of the PCB. After the ground bar has been soldered, the ground bar can be buckled to the PCB, such as by using a pair of tweezers. Figure 11 illustrates a ground bar 1100 soldered to the PCB and adjacent to the terminated wire leads.

## Claims

1. A method for terminating a cable having one or more wires within a connector housing the method comprising the steps of:
cutting and stripping one or more outer layers (702, 704, 706) of the cable (902, 904) enclosing the one or more wires (202, 204, 708, 712);
arranging the one or more wires (202, 204, 708, 712) on a wire holder (200, 210, 500, 600), the arranging comprising positioning and arranging the one or more wires (202, 204, 708, 712) in a set of grooves (666) of the wire holder (200, 210, 500, 600), wherein the set of grooves (666) are aligned with a set of openings (502, 512, 514, 604, 622, 624, 642, 662, 664), wherein the set of grooves (666) guide the one or more wires (202, 204, 708, 712) into the set of openings (502, 512, 514, 604, 622, 624, 642, 662, 664), wherein the wire holder (200, 210, 500, 600) includes the set of openings (502, 512, 514, 604, 622, 624, 642, 662, 664), and wherein the one or more wires (202, 204, 708, 712) are threaded through the set of openings (502, 512, 514, 604, 622, 624, 642, 662, 664);
securing the one or more wires (202, 204, 708, 712) to the wire holder (200, 210, 500, 600);
cutting and stripping one or more layers (718) of the one or more wires (200, 210, 500, 600), the one or more layers (718) enclosing individual wire conductors (220, 720);
dipping the individual wire conductors (220, 720) in a conductive metal prior to placing the individual wire conductors (220, 720) on top of corresponding traces (222) on a printed circuit board (PCB);
enclosing the PCB within a PCB holder (218);
aligning the individual wire conductors (220, 720) with the one or more traces (222);
terminating the individual wire conductors (220, 720) to the one or more traces (222);
terminating a ground bar (1100) to the PCB; and removing at least a portion (510, 614, 630) of the wire holder (200, 210, 500, 600) from the connector housing during a manufacturing process of cables and connectors.

2. The method as recited in claim 1, wherein the step of cutting and stripping one or more outer layers of the cable includes the step of cutting the cable to a target length.

3. The method as recited in claim 1, wherein the step of aligning the individual wire conductors further comprises the step of cutting the individual wire conductors to a second target length.

4. The method as recited in any preceding claim, wherein the ground bar is soldered adjacent to the ends of the individual wire conductors.

5. The method as recited in any preceding claim, wherein the step of dipping the individual wire conductors further comprises the step of flattening the wire conductors after they are dipped in the conductive metal.

6. The method as recited in any preceding claim, wherein the step of flattening is performed with flat nose pliers, or
wherein the step of flattening is performed with a press machine.

7. A wire holder for securing and arranging a plurality of wires for termination within a connector housing, comprising:
a wall (504, 602, 626, 646), forming one or more openings (502, 512, 514, 604, 622, 624, 642, 662, 664), the one or more openings (502, 512, 514, 604, 622, 624, 642, 662, 664) having a height at least equal to a height of the plurality of wires (202, 204, 708, 712), the one or more openings (502, 512, 514, 604, 622, 624, 642, 662, 664) having a depth for fitting a portion of the plurality of wires (202, 204, 708, 712); **characterised by**:
a base (506, 608, 628, 648) adjacent to the wall (504, 602, 626, 646) and including one or more grooves (666) aligned with the one or more openings (502, 512, 514, 604, 622, 624, 642, 662, 664), the one or more grooves (666) guiding the plurality of wires (202, 204, 708, 712) into the one or more openings (502, 512, 514, 604, 622, 624, 642, 662, 664), wherein a portion (510, 614, 630) of the wire holder (200, 210, 500, 600) is configured to be removed after the plurality of wires (202, 204, 708, 712) are terminated within the connector during a manufacturing process of cables and connectors.

8. The wire holder as recited in claim 7, wherein the one or more openings include physical properties, wherein one or more first physical properties of a first opening among the one or more openings are different from the one or more second physical properties of a second opening among the one or more openings.

9. The wire holder as recited in claim 7 or claim 8, wherein an opening among the one or more openings fits two or more wires among the plurality of wires, and wherein the opening includes a divider for separating the two or more wires.

10. The wire holder as recited in anyone of claims 7 to 9, wherein the plurality of wires are threaded through the one or more openings.

11. The wire holder as recited in any one of claims 7 to 10, wherein the base includes a first side wall and a second side wall perpendicular to the wall, wherein the first side wall is positioned at a first end of the base, and wherein the second side wall is positioned at a second end of the base.

12. The wire holder as recited in claim 11, wherein the base forms a first side opening between the first side and the first side wing, and wherein the base forms a second side opening between the second side and the second side wing.

13. The wire holder as recited in anyone of claims 7 to 12, wherein the plurality of wires are terminated to one or more traces of a printed circuit board (PCB) within the connector housing, further comprising a PCB holder consisting of a bottom face and a top face, wherein the bottom face includes one or more bottom features locking into one or more top features on the top face when the top face is pressed against the bottom face, wherein the PCB holder encloses the PCB during at least the termination of the plurality of wires.

14. The wire holder as recited in claim 13, wherein the PCB holder includes one or more indentations for aligning one or more ends of the plurality of wires with the one or more traces.

15. The wire holder as recited in anyone of claims 7 to 14, wherein the base includes a substantially rectangular shaped first side wing and a substantially rectangular shaped second side wing, wherein the first side wing extends laterally and outward from a first side of the base, and wherein the second side wing extends laterally and outward from a second side of the base.

## Patentansprüche

1. Verfahren zum Abschließen eines Kabels mit einem oder mit mehreren Drähten innerhalb eines Verbindergehäuses, wobei das Verfahren die folgenden Schritte umfasst:
Abschneiden und Abisolieren einer oder mehrerer Außenschichten (702, 704, 706) des Kabels (902, 904), die den einen oder die mehreren Drähte (202, 204, 708, 712) einschließen;
Anordnen des einen oder der mehreren Drähte (202, 204, 708, 712) an einem Drahthalter (200, 210, 500, 600), wobei das Anordnen das Positionieren und Anordnen des einen oder der mehreren Drähte (202, 204, 708, 712) in einer Menge von Nuten (666) des Drahthalters (200, 210, 500, 600) umfasst, wobei die Menge von Nuten (666) auf eine Menge von Öffnungen (502, 512, 514, 604, 622, 624, 642, 662, 664) ausgerichtet sind, wobei die Menge der Nuten (666) den einen oder die mehreren Drähte (202, 204, 708, 712) in die Menge von Öffnungen (502, 512, 514, 604, 622, 624, 642, 662, 664) führen, wobei der Drahthalter (200, 210, 500, 600) die Menge von Öffnungen (502, 512, 514, 604, 622, 624, 642, 662, 664) enthält und wobei der eine oder die mehreren Drähte (202, 204, 708, 712) durch die Menge von Öffnungen (502, 512, 514, 604, 622, 624, 642, 662, 664) gezogen werden;
Befestigen des einen oder der mehreren Drähte (202, 204, 708, 712) an dem Drahthalter (200, 210, 500, 600) ;
Abschneiden und Abisolieren einer oder mehrerer Schichten (718) des einen oder der mehreren Drähte (200, 210, 500, 600), wobei die eine oder die mehreren Schichten (718) einzelne Drahtadern (220, 720) einschließen;
Tauchen der einzelnen Drahtadern (220, 720) in ein leitendes Metall vor dem Platzieren der einzelnen Drahtadern (220, 720) auf entsprechenden Leiterbahnen (222) auf einer Leiterplatte (PCB);
Einschließen der PCB innerhalb eines PCB-Halters (218) ;
Ausrichten der einzelnen Drahtadern (220, 720) auf die eine oder auf die mehreren Leiterbahnen (222);
Abschließen der einzelnen Drahtadern (220, 720) an der einen oder an den mehreren Leiterbahnen (222);
Abschließen einer Erdsammelschiene (1100) an der PCB; und
Entfernen wenigstens eines Abschnitts (510, 614, 630) des Drahthalters (200, 210, 500, 600) von dem Verbindergehäuse während eines Herstellungsprozesses der Kabel und Verbinder.

2. Verfahren nach Anspruch 1, wobei der Schritt des Abschneidens und Abisolierens einer oder mehrerer Außenschichten des Kabels den Schritt des Abschneidens des Kabels auf eine Solllänge enthält.

3. Verfahren nach Anspruch 1, wobei der Schritt des Ausrichtens der einzelnen Drahtadern ferner den Schritt des Abschneidens der einzelnen Drahtadern auf eine zweite Solllänge umfasst.

4. Verfahren nach einem vorhergehenden Anspruch, wobei die Erdsammelschiene angrenzend an die Enden der einzelnen Drahtadern angelötet wird.

5. Verfahren nach einem vorhergehenden Anspruch, wobei der Schritt des Tauchens der einzelnen Drahtadern ferner den Schritt des Abflachens der Drahtadern, nachdem sie in das leitende Metall getaucht worden sind, umfasst.

6. Verfahren nach einem vorhergehenden Anspruch, wobei der Schritt des Abflachens mit einer Flachzange ausgeführt wird, oder
wobei der Schritt des Abflachens mit einer Pressmaschine ausgeführt wird.

7. Drahthalter zum Befestigen und Anordnen mehrerer Drähte zum Abschluss innerhalb eines Verbindergehäuses, wobei der Drahthalter Folgendes umfasst:
eine Wand (504, 602, 626, 646), die eine oder mehrere Öffnungen (502, 512, 514, 604, 622, 624, 642, 662, 664) bildet, wobei die eine oder die mehreren Öffnungen (502, 512, 514, 604, 622, 624, 642, 662, 664) eine Höhe aufweisen, die wenigstens gleich einer Höhe der mehreren Drähte (202, 204, 708, 712) ist, wobei die eine oder die mehreren Öffnungen (502, 512, 514, 604, 622, 624, 642, 662, 664) eine Tiefe zum Einpassen eines Abschnitts der mehreren Drähte (202, 204, 708, 712) aufweisen; **gekennzeichnet durch**:
eine Grundplatte (506, 608, 628, 648), die an die Wand (504, 602, 626, 646) angrenzt und eine oder mehrere Nuten (666) enthält, die auf die eine oder die mehreren Öffnungen (502, 512, 514, 604, 622, 624, 642, 662, 664) ausgerichtet sind, wobei die eine oder die mehreren Nuten (666) die mehreren Drähte (202, 204, 708, 712) in die eine oder in die mehreren Öffnungen (502, 512, 514, 604, 622, 624, 642, 662, 664) führen, wobei ein Abschnitt (510, 614, 630) des Drahthalters (200, 210, 500, 600) dafür konfiguriert ist, entfernt zu werden, nachdem die mehreren Drähte (202, 204, 708, 712) während eines Herstellungsprozesses der Kabel und Verbinder innerhalb des Verbinders abgeschlossen worden sind.

8. Drahthalter nach Anspruch 7, wobei die eine oder die mehreren Öffnungen physikalische Eigenschaften enthalten, wobei die eine oder die mehreren ersten physikalischen Eigenschaften einer ersten Öffnung unter der einen oder den mehreren Öffnungen von der einen oder den mehreren zweiten physikalischen Eigenschaften einer zweiten Öffnung unter der einen oder den mehreren Öffnungen verschieden sind.

9. Drahthalter nach Anspruch 7 oder Anspruch 8, wobei in eine Öffnung unter der einen oder den mehreren Öffnungen zwei oder mehr Drähte unter den mehreren Drähten passen und wobei die Öffnung eine Trennwand zum Trennen der zwei oder mehr Drähte enthält.

10. Drahthalter nach einem der Ansprüche 7 bis 9, wobei die mehreren Drähte durch die eine oder die mehreren Öffnungen gezogen sind.

11. Drahthalter nach einem der Ansprüche 7 bis 10, wobei die Grundplatte eine erste Seitenwand und eine zweite Seitenwand senkrecht zu der Wand enthält, wobei die erste Seitenwand an einem ersten Ende der Grundplatte positioniert ist und wobei die zweite Seitenwand an einem zweiten Ende der Grundplatte positioniert ist.

12. Drahthalter nach Anspruch 11, wobei die Grundplatte zwischen der ersten Seite und dem ersten Seitenflügel eine erste Seitenöffnung bildet und wobei die Grundplatte zwischen der zweiten Seite und dem zweiten Seitenflügel eine zweite Seitenöffnung bildet.

13. Drahthalter nach einem der Ansprüche 7 bis 12, wobei die mehreren Drähte an einer oder an mehreren Leiterbahnen einer Leiterplatte (PCB) innerhalb des Verbindergehäuses abgeschlossen sind und wobei der Drahthalter ferner einen PCB-Halter umfasst, der aus einer Unterseite und aus einer Oberseite besteht, wobei die Unterseite eines oder mehrere untere Merkmale enthält, die in einem oder in mehreren oberen Merkmalen auf der Oberseite verriegeln, wenn die Oberseite gegen die Unterseite gedrückt wird, wobei der PCB-Halter die PCB wenigstens während des Abschließens der mehreren Drähte einschließt.

14. Drahthalter nach Anspruch 13, wobei der PCB-Halter eine oder mehrere Vertiefungen zum Ausrichten eines oder mehrerer Enden der mehreren Drähte auf die eine oder die mehreren Leiterbahnen enthält.

15. Drahthalter nach einem der Ansprüche 7 bis 14, wobei die Grundplatte einen im Wesentlichen rechteckförmigen ersten Seitenflügel und einen im Wesentlichen rechteckförmigen zweiten Seitenflügel enthält, wobei der erste Seitenflügel von einer ersten Seite der Grundplatte seitlich und nach außen verläuft und wobei der zweite Seitenflügel von einer zweiten Seite der Grundplatte seitlich und nach außen verläuft.

## Revendications

1. Procédé pour terminer un câble ayant un ou plusieurs conducteurs à l'intérieur d'un boîtier de connecteur, ce procédé comprenant les étapes consistant à :
couper et dénuder une ou plusieurs couches externes (702, 704, 706) du câble (902, 904) renfermant le ou les conducteurs (202, 204, 708, 712) ;
disposer le ou les conducteurs (202, 204, 708, 712) sur un porte-conducteur (200, 210, 500, 600), cet acte de disposition comprenant le positionnement et la disposition du ou des conducteurs (202, 204, 708, 712) dans un ensemble de gorges (666) du porte-conducteur (200, 210, 500, 600), cet ensemble de gorges (666) étant aligné avec un ensemble d'ouvertures (502, 512, 514, 604, 622, 624, 642, 662, 664), cet ensemble de gorges (666) guidant le ou les fils (202, 204, 708, 712) dans l'ensemble d'ouvertures (502, 512, 514, 604, 622, 624, 642, 662, 664), le porte-conducteur (200, 210, 500, 600) comprenant un ensemble d'ouvertures (502, 512, 514, 604, 622, 624, 642, 662, 664), et le ou les conducteurs (202, 204, 708, 712) étant enfilés à travers l'ensemble d'ouvertures (502, 512, 514, 604, 622, 624, 642, 662, 664) ;
fixer le ou les conducteurs (202, 204, 708, 712) au porte-conducteur (200, 210, 500, 600) ;
couper et dénuder une ou plusieurs couches (718) du ou des conducteurs (200, 210, 500, 600), cette couche ou ces couches (718) renfermant des fils conducteurs individuels (220, 720) ;
tremper les fils conducteurs individuels (220, 720) dans un métal conducteur avant de placer les fils conducteurs individuels (220, 720) au-dessus des tracés correspondants (222) sur une carte de circuit imprimé (CCI) ;
renfermer la CCI à l'intérieur d'un porte-CCI (218) ;
aligner les fils conducteurs individuels (220, 720) avec le ou les tracés (222) ;
terminer les fils conducteurs individuels (220, 720) en les connectant au tracé ou aux tracés (222) ;
terminer une barre de terre (1100) en la connectant à la CCI ; et à
enlever au moins une partie (510, 614, 630) du porte-conducteur (200, 210, 500, 600) du boîtier de connecteur pendant un processus de fabrication des câbles et des connecteurs.

2. Procédé selon la revendication 1, dans lequel l'étape de coupe et de dénudage d'une ou de plusieurs couches du câble comprend l'étape de coupe du câble à une longueur cible.

3. Procédé selon la revendication 1, dans lequel l'étape d'alignement des fils conducteurs individuels comprend en outre l'étape de coupe des fils conducteurs individuels à une deuxième longueur cible.

4. Procédé selon l'une quelconque des revendications précédentes, dans lequel la barre de terre est brasée en position adjacente aux extrémités des fils conducteurs individuels.

5. Procédé selon l'une quelconque des revendications précédentes, dans lequel l'étape de trempage des fils conducteurs individuels comprend en outre l'étape d'aplatissement des fils conducteurs après leur trempage dans le métal conducteur.

6. Procédé selon l'une quelconque des revendications précédentes, dans lequel l'étape d'aplatissement est exécutée avec une pince à bec plat, ou
dans lequel l'étape d'aplatissement est exécutée avec une presse.

7. Porte-conducteur pour fixer et disposer une pluralité de conducteurs pour les terminer à l'intérieur d'un boîtier de connecteur, comprenant :
une paroi (504, 602, 626, 646), formant une ou plusieurs ouvertures (502, 512, 514, 604, 622, 624, 642, 662, 664), cette ouverture ou ces ouvertures (502, 512, 514, 604, 622, 624, 642, 662, 664) ayant une hauteur au moins égale à une hauteur de la pluralité de conducteurs (202, 204, 708, 712), cette ouverture ou ces ouvertures (502, 512, 514, 604, 622, 624, 642, 662, 664) ayant une profondeur pour y monter une partie de la pluralité de conducteurs (202, 204, 708, 712) ; **caractérisé par** :
une base (506, 608, 628, 648) adjacente à la paroi (504, 602, 626, 646) et comprenant une ou plusieurs gorges (666) alignées avec la ou les ouvertures (502, 512, 514, 604, 622, 624, 642, 662, 664), cette gorge ou ces gorges (666) guidant la pluralité de conducteurs (202, 204, 708, 712) dans la ou les ouvertures (502, 512, 514, 604, 622, 624, 642, 662, 664), une partie (510, 614, 630) du porte-conducteur (200, 210, 500, 600) étant configurée de façon à être enlevée après que la pluralité de conducteurs (202, 204, 708, 712) ont été terminés à l'intérieur du connecteur pendant un processus de fabrication des câbles et des connecteurs.

8. Porte-conducteur selon la revendication 7, dans lequel la ou les ouvertures comportent des propriétés physiques, une ou plusieurs premières propriétés physiques d'une première ouverture parmi la ou les ouvertures étant différentes de la ou des deuxièmes propriétés physiques d'une deuxième ouverture parmi la ou les ouvertures.

9. Porte-conducteur selon la revendication 7 ou la revendication 8, dans lequel une ouverture parmi la ou les ouvertures permet d'y monter un ou plusieurs conducteurs parmi la pluralité de conducteurs, et dans lequel cette ouverture comprend un diviseur pour séparer les deux conducteurs ou plus.

10. Porte-conducteur selon l'une quelconque des revendications 7 à 9, dans lequel la pluralité de conducteurs sont enfilés à travers la ou les ouvertures.

11. Porte conducteur selon l'une quelconque des revendications 7 à 10, dans lequel la base comprend une première paroi latérale et une deuxième paroi latérale perpendiculaire à la paroi, dans lequel la première paroi latérale est positionnée à une première extrémité de la base, et dans lequel la deuxième paroi latérale est positionnées à une deuxième extrémité de la base.

12. Porte-conducteur selon la revendication 11, dans lequel la base forme une première ouverture latérale entre le premier côté et la première aile latérale, et dans lequel la base forme une deuxième ouverture entre le deuxième côté et la deuxième aile latérale.

13. Porte-conducteur selon l'une quelconque des revendications 7 à 12, dans lequel la pluralité de conducteurs sont terminés en les connectant à une ou plusieurs tracés d'une carte de circuit imprimé (CCI) à l'intérieur du boîtier du connecteur, comprenant en outre un porte-conducteur consistant en une face inférieure et une face supérieure, la face inférieure comprenant une ou plusieurs caractéristiques inférieures se bloquant dans une ou plusieurs caractéristiques supérieures sur la face supérieure lorsque la face supérieure est pressée contre la face inférieure, le porte-conducteur renfermant la CCI pendant au moins la terminaison de la pluralité de conducteurs.

14. Porte-conducteur selon la revendication 13, dans lequel le porte-CCI comprend une ou plusieurs renfoncements pour aligner une ou plusieurs extrémités de la pluralité de conducteurs avec le ou les tracés.

15. Porte-conducteur selon l'une quelconque des revendications 7 à 14, dans lequel la base comprend une première aile latérale de forme essentiellement rectangulaire et une deuxième aile latérale de forme essentiellement rectangulaire, la première aile latérale s'étendant latéralement et vers l'extérieur depuis un premier côté de la base, et la deuxième aile latérale s'étendant latéralement et vers l'extérieur depuis un deuxième côté de la base.
